# EUROPEAN PATENT APPLICATION

(11) **EP 4 738 429 A1**
(43) Date of publication of application: **06.05.2026**
(21) Application number: 23943686.8
(22) Date of filing: 29.06.2023
(51) Int. Cl.: H01L 21/3065

(54) **PROCESSING METHOD, PROCESSING DEVICE, METHOD FOR PRODUCING SEMICONDUCTOR DEVICE, AND PROGRAM**

(71) Applicant: Kokusai Electric Corporation, Tokyo 101-0045 (JP)
(72) Inventor: OGAWA, Arito, Toyama-shi, Toyama 939-2393 (JP)
(74) Representative: Bardehle Pagenberg Partnerschaft mbB Patentanwälte Rechtsanwälte
(86) International application number: PCT/JP2023/024287
(87) International publication number: WO 2025/004295

(57) **Abstract**

There is provided a technique capable of improving surface roughness of a film, including: (a) forming a second film, whose etching rate is a second etching rate that is equal to or lower than a first etching rate of a first film when a first gas capable of removing at least a portion of the first film is supplied, on the first film; and (b) supplying the first gas to the first film.

## Description

### TECHNICAL FIELD

The present disclosure relates to a processing method, a processing apparatus, a method of manufacturing a semiconductor device, and a program.

### BACKGROUND

As a process of manufacturing a semiconductor device, a process may be performed in which a crystalline layer separation film is formed on the surface of a metal-containing film or abnormal growth nuclei on the surface of the metal-containing film are removed, thereby forming a plurality of layers of metal-containing films on a substrate (*see,* for example, Patent Document 1).

### [Prior Art Documents]

### [Patent Documents]

Patent Document 1: International Laid-Open Publication No. 2021/053761

### SUMMARY

The present disclosure provides a technique capable of improving the roughness of the surface (hereinafter referred to as "surface roughness") of a film.

According to embodiments of the present disclosure, there is provided a technique including: (a) forming a second film, whose etching rate is a second etching rate that is equal to or lower than a first etching rate of a first film when a first gas capable of removing at least a portion of the first film is supplied, on the first film; and (b) supplying the first gas to the first film.

According to the present disclosure, it is possible to improve the surface roughness of a film.

### BRIEF DESCRIPTION OF DRAWINGS

FIG. 1 is a longitudinal cross-sectional view schematically illustrating a vertical process furnace of a substrate processing apparatus according to embodiments of the present disclosure.
FIG. 2 is a schematic transverse cross-sectional view taken along line A-A in FIG. 1.
FIG. 3 is a schematic configuration diagram of a controller of a substrate processing apparatus according to embodiments of the present disclosure, in which a control system of the controller is illustrated in a block diagram.
FIG. 4 is a diagram illustrating a process flow according to embodiments of the present disclosure.
FIG. 5 is a flowchart illustrating first cleaning processing in the process flow of FIG. 4.
FIG. 6A is a diagram illustrating the state of a surface inside a reaction tube before cleaning processing is performed, and FIG. 6B is a diagram illustrating the state of the surface inside the reaction tube when the cleaning processing is performed in the state shown in FIG. 6A.
FIG. 7A is a diagram illustrating the state of the surface inside the reaction tube before cleaning processing is performed, FIG. 7B is a diagram illustrating the state of the surface inside the reaction tube when treatment processing is performed in the state shown in FIG. 7A, and FIG. 7C is a diagram illustrating the state of the surface inside the reaction tube when the cleaning processing is performed in the state shown in FIG. 7B.
FIG. 8 is a flowchart illustrating first cleaning processing according to embodiments of the present disclosure.
FIG. 9 is a flowchart illustrating first cleaning processing according to embodiments of the present disclosure.

### DETAILED DESCRIPTION

### <Embodiments of Present Disclosure>

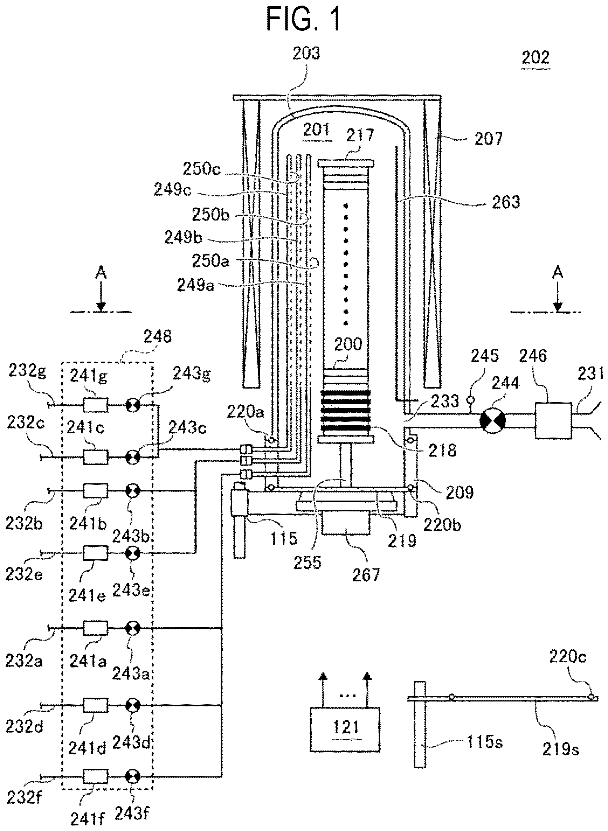

Hereinafter, embodiments of the present disclosure will be described mainly with reference to FIGS. 1 to 5, 6A, 6B, and 7A to 7C. The drawings used in the following description are schematic, and the dimensional relationship of each element, the ratio of each element, and the like shown in the drawings may not match the actual ones. Further, even among the drawings, the dimensional relationship of each element, the ratio of each element, and the like may not match.

### (1) Configuration of Substrate Processing Apparatus

As illustrated in FIG. 1, a process furnace 202 includes a heater 207 as a temperature adjuster (a heating portion). The heater 207 with a cylindrical shape and is supported by a holding plate to be vertically installed. The heater 207 also functions as an activator (an excitation portion) that thermally activates (excites) a gas.

Inside the heater 207, a reaction tube 203 is disposed concentrically with the heater 207. The reaction tube 203 is made of, for example, a heat resistant material such as quartz (SiO₂) or silicon carbide (SiC) and with a cylindrical shape, an upper end of which is closed and a lower end of which is opened. A manifold 209 is disposed concentrically with the reaction tube 203 below the reaction tube 203. The manifold 209 is made of, for example, a metal material such as stainless steel (SUS) and with a cylindrical shape, upper and lower ends of which are opened. The upper end of the manifold 209 engages with the lower end of the reaction tube 203 and is configured to support the reaction tube 203. An O-ring 220a as a seal is provided between the manifold 209 and the reaction tube 203. Similar to the heater 207, the reaction tube 203 is vertically installed. A process container (reaction container) is mainly composed of the reaction tube 203 and the manifold 209. A process chamber 201 is formed in a cylindrical hollow portion of the process container. The process chamber 201 is configured to be capable of accommodating wafers 200 as substrates.

Nozzles 249a to 249c as first to third supplier are provided in the process chamber 201 so as to penetrate a sidewall of the manifold 209. The nozzles 249a to 249c will be also referred to as first to third nozzles, respectively. The nozzles 249a to 249c are each made of, for example, a heat resistant material such as SiO₂ or SiC. Gas supply pipes 232a to 232c are connected to the nozzles 249a to 249c, respectively.

Mass flow controllers (MFCs) 241a to 241c, which are flow rate controllers (flow rate control portions), and valves 243a to 243c, which are opening/closing valves, are respectively provided at the gas supply pipes 232a to 232c sequentially from corresponding upstream sides of gas flows. Gas supply pipes 232d and 232f are each connected downstream of the valve 243a of the gas supply pipe 232a. A gas supply pipe 232e is connected downstream of the valve 243b of the gas supply pipe 232b. A gas supply pipe 232g is connected downstream of the valve 243c of the gas supply pipe 232c. MFCs 241d to 241g and valves 243d to 243g are respectively provided at the gas supply pipes 232d to 232g sequentially from corresponding upstream sides of gas flows.

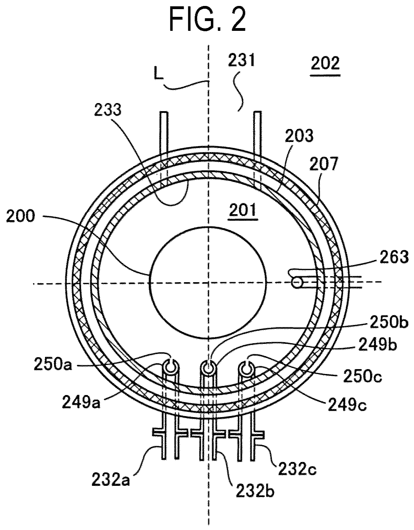

As illustrated in FIG. 2, the nozzles 249a to 249c are provided in a space with an annular shape in a plane view between an inner wall of the reaction tube 203 and the wafers 200 such that the nozzles 249a to 249c are raised upward in an arrangement direction of the wafers 200 from a lower portion to an upper portion of the inner wall of the reaction tube 203. Namely, the nozzles 249a to 249c are provided on lateral sides of the wafer arrangement region in which the wafers 200 are arranged, that is, in a region which horizontally surrounds the wafer arrangement region, so as to extend along the wafer arrangement region. In a plane view, the nozzle 249b is disposed to face an exhaust port 233, which will be described later, on a straight line, with centers of the wafers 200, which are loaded into the process chamber 201, interposed between the nozzle 249b and the exhaust port 233. The nozzles 249a and 249c are disposed to sandwich a straight line L passing through the nozzle 249b and a center of the exhaust port 233 from both sides along the inner wall of the reaction tube 203 (an outer peripheral portion of the wafers 200). Gas supply holes 250a to 250c configured to supply gases are respectively provided on side surfaces of the nozzles 249a to 249c. The gas supply holes 250a to 250c are respectively opened to face the exhaust port 233 in a plane view, which enables gases to be supplied toward the wafers 200. The gas supply holes 250a to 250c may be formed in plurality from the lower portion to the upper portion of the reaction tube 203.

A first process gas is supplied from the gas supply pipe 232a into the process chamber 201 via the MFC 241a, the valve 243a, and the nozzle 249a. An example of the first process gas can include a material gas. The material gas can include, for example, a metal-containing gas including a metal element, a silicon (Si)-containing gas, and the like.

A second process gas is supplied from the gas supply pipe 232b into the process chamber 201 via the MFC 241b, the valve 243b, and the nozzle 249b. An example of the second process gas can include a reaction gas. The reaction gas can include, for example, a nitriding gas.

A third process gas is supplied from the gas supply pipe 232c into the process chamber 201 via the MFC 241c, the valve 243c, and the nozzle 249c. The third process gas can include, for example, a reducing gas, and a treatment gas (also referred to as a modification gas) as a second gas. The third process gas may include, for example, a gas containing Si and hydrogen (H).

A cleaning gas as a first gas is supplied from the gas supply pipe 232d into the process chamber 201 via the MFC 241d, the valve 243d, the gas supply pipe 232a, and the nozzle 249a. As the cleaning gas, for example, a halogen-containing gas, which is a halogen-based gas, can be used.

Inert gases are supplied from the gas supply pipes 232e to 232g into the process chamber 201 via the respective MFCs 241e to 241g, valves 243e to 243g, gas supply pipes 232e to 232g, and nozzles 249a to 249c. The inert gases serve as purge gases, carrier gases, or dilution gases.

A first process gas supply system (also referred to as a raw material gas supply system) is mainly composed of the gas supply pipe 232a, the MFC 241a, and the valve 243a. A second process gas supply system (also referred to as a reaction gas supply system) is mainly composed of the gas supply pipe 232b, the MFC 241b, and the valve 243b. A third process gas supply system (also referred to as a reducing gas supply system, a second gas supply system, a treatment gas supply system, or a modification gas supply system) is mainly composed of the gas supply pipe 232c, the MFC 241c, and the valve 243c. A cleaning gas supply system (also referred to as a first gas supply system) is mainly composed of the gas supply pipe 232d, the MFC 241d, and the valve 243d. An inert gas supply system is mainly composed of the gas supply pipes 232e to 232g, the MFCs 241e to 241g, and the valves 243e to 243g.

Any of or the entire above-described various gas supply systems may be configured as an integrated supply system 248 in which the valves 243a to 243g, the MFCs 241a to 241g, or the like are integrated. The integrated supply system 248 is connected to each of the gas supply pipes 232a to 232g such that supply operations of various materials (various gases) into the gas supply pipes 232a to 232g, that is, opening/closing operations of the valves 243a to 243g, flow rate regulating operations by the MFCs 241a to 241g, or the like are configured to be controlled by a controller 121 to be described below. The integrated supply system 248 is configured as an integral type or division type integrated unit and is also configured such that the integrated supply system 248 is detachable from the gas supply pipes 232a to 232g on an integrated unit basis so as to perform maintenance, replacement, expansion, and the like of the integrated supply system 248 on an integrated unit basis.

The exhaust port 233 that exhausts an internal atmosphere of the process chamber 201 is provided below a sidewall of the reaction tube 203. As illustrated in FIG. 2, the exhaust port 233 is installed at a position opposing (facing) the nozzles 249a to 249c (the gas supply holes 250a to 250c) in a plane view, with the wafers 200 interposed therebetween. The exhaust port 233 may be provided from the lower portion to the upper portion of the sidewall of the reaction tube 203, that is, along the wafer arrangement region. An exhaust pipe 231 is connected to the exhaust port 233. A vacuum pump 246 as a vacuum exhauster is connected to the exhaust pipe 231 via a pressure sensor 245, which is a pressure detector (pressure detection portion) which detects the internal pressure of the process chamber 201, and an automatic pressure controller (APC) valve 244, which is a pressure adjustor (pressure adjustment portion). The APC valve 244 is configured to perform vacuum exhaust and vacuum exhaust stop of the interior of the process chamber 201 by opening/closing the valve while the vacuum pump 246 is operated and to adjust the internal pressure of the process chamber 201 by adjusting an opening degree of the valve based on pressure information detected by the pressure sensor 245 while the vacuum pump 246 is operated. An exhaust system is mainly composed of the exhaust pipe 231, the APC valve 244, and the pressure sensor 245. The vacuum pump 246 may be included in the exhaust system.

A seal cap 219, which serves as a furnace opening lid capable of hermetically closing a lower end opening of the manifold 209, is provided below the manifold 209. The seal cap 219 is made of, for example, a metal material such as SUS and is formed in a disc shape. An O-ring 220b, which serves as a seal member contacting the lower end of the manifold 209, is provided on an upper surface of the seal cap 219. A rotator 267 that rotates a boat 217 to be described later is installed below the seal cap 219. A rotary shaft 255 of the rotator 267 penetrates the seal cap 219 and is connected to the boat 217. The rotator 267 is configured to rotate the wafers 200 by rotating the boat 217. The seal cap 219 is configured to be elevated in a vertical direction by a boat elevator 115 which serves as an elevating mechanism installed outside the reaction tube 203. The boat elevator 115 is configured as a transfer device (transfer mechanism) which loads or unloads (transfers) the wafers 200 into and from the process chamber 201 by raising and lowering the seal cap 219.

A shutter 219s, as a furnace opening lid capable of hermetically closing the lower end opening of the manifold 209 in a state in which the boat 217 is unloaded from the interior of the process chamber 201, by moving the seal cap 219 down, is provided below the manifold 209. The shutter 219s is made of, for example, a metal material such as SUS and is formed in a disc shape. An O-ring 220c, which is a seal member contacting the lower end of the manifold 209, is provided on an upper surface of the shutter 219s. An opening/closing operation (elevation operation, rotation operation, or the like) of the shutter 219s is controlled by a shutter opening/closing mechanism 115s.

The boat 217 as a substrate support is configured so as to support a plurality of wafers 200, for example, 25 to 200 wafers in a horizontal orientation and in multiple stages while the wafers 200 are arranged in the vertical direction with the centers of the wafers 200 aligned with one another, that is, so as to arrange the wafers 200 at intervals. The boat 217 is made of a heat resistant material such as SiO₂ or SiC. Heat insulating plates 218 made of a heat resistant material such as SiO₂ or SiC are supported in multiple stages at a lower portion of the boat 217.

A temperature sensor 263 as a temperature detector is installed inside the reaction tube 203. Based on temperature information detected by the temperature sensor 263, a state of supply of electric power to the heater 207 is adjusted such that temperature inside the process chamber 201 becomes a desired temperature distribution. The temperature sensor 263 is provided along the inner wall of the reaction tube 203.

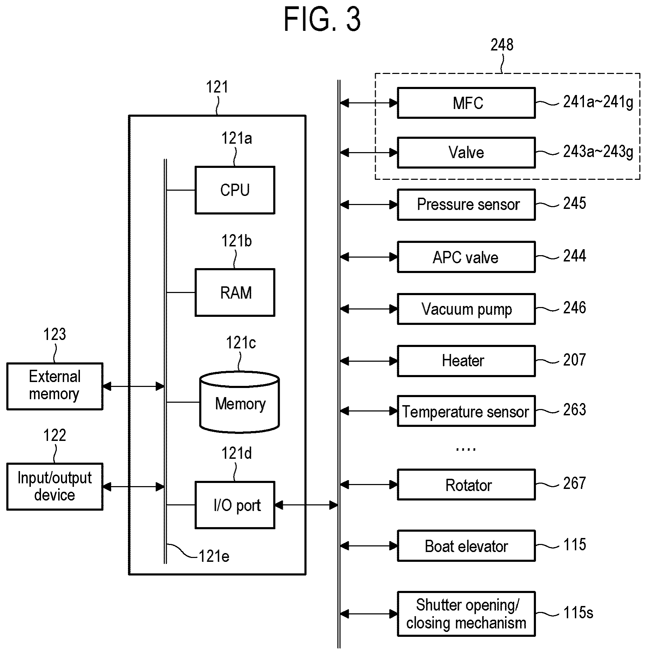

As illustrated in FIG. 3, the controller 121, which is a control portion (control means), is configured as a computer including a central processing unit (CPU) 121a, a random access memory (RAM) 121b, a memory 121c, and an input/output (I/O) port 121d. The RAM 121b, the memory 121c, and the I/O port 121d are configured to exchange data with the CPU 121a via an internal bus 121e. An input/output device 122 configured as, for example, a touch panel, is connected to the controller 121. The controller 121 is also configured to allow connection of an external memory 123.

The memory 121c is composed of, for example, a flash memory, a hard disk drive (HDD), a solid state drive (SSD), or the like. The memory 121c readably stores a control program for controlling the operation of the substrate processing apparatus, a process recipe in which substrate processing procedures or conditions, which will be described later, and the like are written. The process recipe is a combination that causes, by the controller 121, the substrate processing apparatus to execute each procedure in a substrate processing process, which will be described later, so as to obtain a predetermined result. The process recipe functions as a program. Hereinafter, the process recipe or the control program will be collectively referred to simply as a program. Further, the process recipe is also referred to simply as a recipe. When the term "program" is used herein, this may indicate the case in which the process recipe alone is included, the case in which the control program alone is included, or the case in which both the process recipe and the control program are included. The RAM 121b is configured as a memory area (work area) in which programs or data read by the CPU 121a is temporarily held.

The I/O port 121d is connected to the above-described components, such as the MFCs 241a to 241g, the valves 243a to 243g, the pressure sensor 245, the APC valve 244, the vacuum pump 246, the temperature sensor 263, the heater 207, the rotator 267, the boat elevator 115, and shutter opening/closing mechanism 115s.

The CPU 121a is configured to read the control program from the memory 121c and execute the read control program. The CPU 121a is also configured to read the recipe from the memory 121c according to input of an operation command from the input/output device 122. According to the content of the read recipe, the CPU 121a is configured to control various operations such as flow rate regulating operations for various materials (various gases) by the MFCs 241a to 241g, an opening/closing operation of the valves 243a to 243g, an opening/closing operation of the APC valve 244, a pressure adjustment operation by the APC valve 244 based on the pressure sensor 245, a start and stop operation of the vacuum pump 246, a temperature adjustment operation of the heater 207 based on the temperature sensor 263, a rotation and rotation speed adjustment operation of the boat 217 by the rotator 267, a raising and lowering operation of the boat 217 by the boat elevator 115, and an opening/closing operation of the shutter 219s by the shutter opening/closing mechanism 115s.

The controller 121 may be configured by installing, in the computer, the above-described program stored in the external memory 123. The external memory 123 includes, for example, a magnetic disk such as an HDD, an optical disc such as a CD, a magneto-optical disc such as an MO, and a semiconductor memory such as a USB memory or an SSD. The memory 121c or the external memory 123 is configured as a computer-readable recording medium. Hereinafter, the memory 121c or the external memory 123 will be collectively referred to simply as a recording medium. The term "recording medium" used herein may indicate the case in which the memory 121c alone is included, the case in which the external memory 123 alone is included, or the case in which both the memory 121c and the external memory 123 are included. The program may be provided to the computer using communication means such as the Internet or a dedicated line, without using the external memory 123.

### (2) Substrate Processing Process

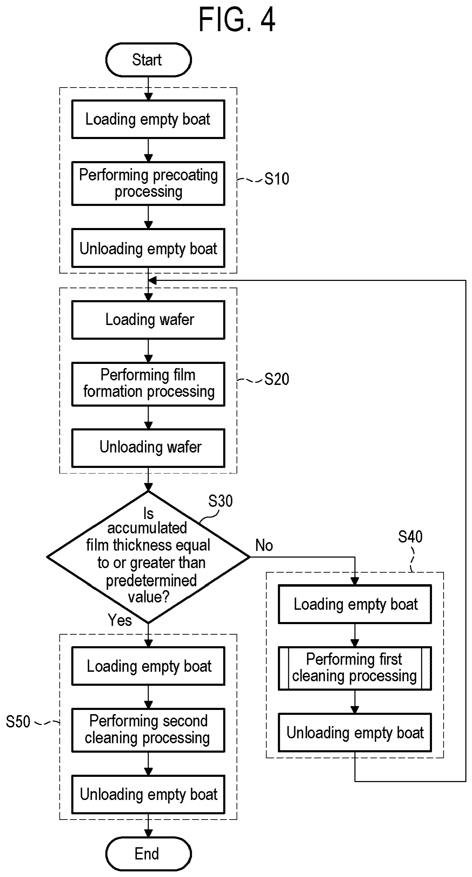

As one process of manufacturing a semiconductor device using the above-described substrate processing apparatus, an example of a processing sequence including film formation processing in which a film is formed on the wafer 200 will be described mainly with reference to FIGS. 4, 5, 6A, 6B, and 7A to 7C. In the following descriptions, the operation of each part constituting the substrate processing apparatus is controlled by the controller 121.

### <Precoating Process, Step S10>

First, a precoating process for forming a precoat film inside the process container before performing a film formation process will be described. The precoat film is also simply referred to as a film.

### [Loading of Empty Boat]

In this process, precoating processing (also referred to as precoating) for forming the precoat film is performed on the surfaces of members inside the process container, such as the inner wall of the reaction tube 203, outer surfaces of the nozzles 249a to 249c, inner surfaces of the nozzles 249a to 249c, an inner surface of the manifold 209, a surface of the boat 217, and the upper surface of the seal cap 219, in a state in which the empty boat 217 is loaded into the process container. The precoating processing may also be performed in a state in which the boat 217 is unloaded.

### [Precoating Processing]

### (Supply of First Process Gas, S11)

In this step, the first process gas is supplied into the process chamber 201. Specifically, the valve 243a is opened to allow the first process gas to flow into the gas supply pipe 232a. A flow rate of the first process gas is controlled by the MFC 241a, supplied into the process chamber 201 via the nozzle 249a, and then exhausted through the exhaust port 233. In this case, the valve 243f is opened simultaneously to allow the inert gas to flow into the gas supply pipe 232a. In order to prevent the first process gas from entering the nozzles 249b and 249c, the valves 243e and 243g may be opened to allow the inert gas to flow into the gas supply pipes 232b and 232c.

In this case, the first process gas is supplied into the process container. Here, for example, a metal-containing gas can be used as the first process gas. As the metal-containing gas, for example, a transition metal-containing gas can be used. The transition metal-containing gas includes, for example, a gas containing titanium (Ti), tungsten (W), molybdenum (Mo), or tantalum (Ta). For example, titanium tetrachloride (TiCl₄) gas can be used as the Ti-containing gas. As the metal-containing gas, for example, a gas containing aluminum (Al), gallium (Ga), or indium (In) can also be used. Furthermore, as the first process gas, for example, a Si-containing gas can be used in addition to the metal-containing gas. One or more of these gases can be used as the first process gas.

As the inert gas, a noble gas such as nitrogen (N₂) gas, argon (Ar) gas, helium (He) gas, neon (Ne) gas, or xenon (Xe) gas can be used. One or more of these gases can be used as the inert gas. The same applies to each step described below.

### (Purge S12)

After a predetermined period of time has elapsed since the start of the supply of the first process gas, the valve 243a is closed to stop the supply of the first process gas into the process chamber 201. Then, the process chamber 201 is vacuum-exhausted to remove any residual gases remaining in the process chamber 201 from the interior thereof (Purge). In this case, the valves 243e, 243f, and 243g are opened to supply an inert gas into the process chamber 201. The inert gas serves as a purge gas.

### (Supply of Second Process Gas, S13)

Next, the second process gas is supplied into the process chamber 201. Specifically, the valve 243b is opened to allow the second process gas to flow into the gas supply pipe 232b. A flow rate of the second process gas is controlled by the MFC 241b, supplied into the process chamber 201 via the nozzle 249b, and then exhausted through the exhaust port 233. In this case, the valve 243e is opened simultaneously to allow the inert gas to flow into the gas supply pipe 232b. In order to prevent the second process gas from entering the nozzles 249a and 249c, the valves 243f and 243g may be opened to allow the inert gas to flow into the gas supply pipes 232a and 232c.

In this case, the second process gas is supplied into the process container. As the second process gas, for example, a nitriding gas or the like is used. As the nitriding gas, for example, a hydrogen nitride-based gas such as ammonia (NH₃) gas, diazene (N₂H₂) gas, hydrazine (N₂H₄) gas, or N₃H₈ gas can be used. One or more of these gases can be used as the second process gas.

### (Purge S14)

After a predetermined time has elapsed since the start of the supply of the second process gas, the valve 243b is closed to stop the supply of the second process gas into the process chamber 201. Then, residual gases remaining in the process chamber 201 are removed from the interior thereof by the same processing procedure as in the purge step S12 described above (Purge).

### (Performing Cycle Predetermined Number of Times, S15)

By performing a cycle including S11 to S14 described above, i.e., performing S11 to S14 non-simultaneously a predetermined number of times (X times, where X is an integer of 1, 2, or greater), a film of predetermined composition and predetermined thickness can be formed on a member inside the process container. Here, for example, a titanium nitride (TiN) film is formed.

### (Supply of Third Process Gas, S16)

After performing the above-described cycle in which steps S11 to S14 are performed in this order a predetermined number of times, the third process gas is supplied into the process chamber 201. Specifically, the valve 243c is opened to allow the third process gas to flow into the gas supply pipe 232c. A flow rate of the third process gas is controlled by the MFC 241c, supplied into the process chamber 201 via the nozzle 249c, and then exhausted through the exhaust port 233. In this case, the valve 243g is opened simultaneously to allow the inert gas to flow into the gas supply pipe 232c. In order to prevent the third process gas from entering the nozzles 249a and 249b, the valves 243f and 243e may be opened to allow the inert gas to flow into the gas supply pipes 232a and 232b.

In this case, the third process gas is supplied into the process container. Here, the third process gas can be, for example, a gas containing Si and H. The Si- and H-containing gas can be, for example, a silane-based gas such as monosilane (SiH₄) gas, disilane (Si₂H₆) gas, or trisilane (Si₃H₈) gas. One or more of these gases can be used as the third process gas.

### (Purge S17)

After a predetermined time has elapsed since the start of the supply of the third process gas, the valve 243c is closed to stop the supply of the third process gas into the process chamber 201. Then, residual gases remaining in the process chamber 201 are removed from the interior thereof by the same processing procedure as in the purge step S12 described above (Purge).

### (Performing Cycle Predetermined Number of Times)

By performing a cycle including S15 to S17 described above, i.e., performing S15 to S17 non-simultaneously a predetermined number of times (Y times, where Y is an integer of 1, 2, or greater), a precoat film of predetermined thickness is formed on a member inside the process container. Here, for example, a titanium silicon nitride (TiSiN) film is formed as the precoat film.

The precoating processing is terminated by a series of operations described above. By forming the precoat film, adhesion to the inner wall of the process container is improved, and it is difficult to peel off the film from the inner wall. In addition, the surface roughness of an initial film of the precoat film can be reduced.

In addition, the above-described precoating processing makes it possible to suppress the occurrence of a film thickness drop phenomenon during film formation. In addition, the above-described precoating processing makes it possible to adjust the environment and state inside the process container before the next film formation processing.

The order and timing of supplying the first process gas, the second process gas, and the third process gas in the above-described precoating processing are not limited to the above-described order or timing.

### [Unloading of Empty Boat]

After the precoating processing is completed, the seal cap 219 is lowered by the boat elevator 115, and the lower end of the manifold 209 is opened. Then, the empty boat 217 is unloaded from the lower end of the manifold 209 to the outside of the reaction tube 203 (Boat Unloading).

### <Film Formation Process, Step S20>

Next, the film formation process in which the wafer 200 is loaded into the process furnace 202 and a film is formed on the wafer 200 will be described. That is, in this process, the film formation process for processing the wafer 200 inside the process container is performed.

The term "wafer" used herein may refer to the wafer itself or a laminated body of the wafer and a predetermined layer or film formed on a surface of the wafer. The term "the surface of the wafer" used herein may refer to the surface of the wafer itself or the surface of a predetermined layer and the like formed on the wafer. The expression "forming a predetermined layer on a wafer" used herein may refer to directly forming a predetermined layer on the surface of the wafer itself or forming a predetermined layer on a layer and the like formed on the wafer. The term "substrate" used herein is synonymous with the term "wafer".

### [Loading of Wafer]

When a plurality of wafers 200 is charged onto the boat 217 (Wafer Charging), the boat 217 that supports the plurality of wafers 200 is lifted by the boat elevator 115 and loaded into the process chamber 201, as illustrated in FIG. 1 (Boat Loading). In this state, the seal cap 219 closes a lower end opening of the reaction tube 203 via the O-ring 220b.

The interior of the process chamber 201, i.e., a space in which the wafers 200 are accommodated, is vacuum-exhausted by the vacuum pump 246 so as to reach a desired pressure (a degree of vacuum). In this case, the pressure inside the process chamber 201 is measured by the pressure sensor 245, and the APC valve 244 is feedback-controlled based on information on the measured pressure (Pressure Adjustment). The interior of the process chamber 201 is also heated by the heater 207 so as to reach a desired temperature. In this case, the amount of electric power supplied to the heater 207 is feedback-controlled based on information on the temperature detected by the temperature sensor 263 so that a temperature distribution the interior of the process chamber 201 becomes a desired temperature distribution (Temperature Adjustment). The rotator 267 starts to rotate the wafers 200. The vacuum-exhausting of the process chamber 201 and the heating and rotation of the wafers 200 are continuously performed at least until processing on the wafer 200 is completed.

### [Film Formation Processing]

### (Supply of First Process Gas, S21)

In this step, the first process gas is supplied to the wafers 200 inside the process chamber 201. Specifically, the valve 243a is opened to allow the first process gas to flow into the gas supply pipe 232a. The flow rate of the first process gas is controlled by the MFC 241a, supplied into the process chamber 201 via the nozzle 249a, and then exhausted through the exhaust port 233. In this case, the valve 243f is opened simultaneously to allow the inert gas to flow into the gas supply pipe 232a. In order to prevent the first process gas from entering the nozzles 249b and 249c, the valves 243e and 243g may be opened to allow the inert gas to flow into the gas supply pipes 232b and 232c.

In this case, the first process gas described above is supplied to the wafers 200.

### (Purge S22)

After a predetermined period of time has elapsed since the start of the supply of the first process gas, the valve 243a is closed to stop the supply of the first process gas into the process chamber 201. Then, residual gases remaining in the process chamber 201 are removed from the interior thereof by the same processing procedure as in the purge step S12 described above (Purge).

### (Supply of Second Process Gas, S23)

Next, the second process gas is supplied to the wafer 200 inside the process chamber 201. Specifically, the valve 243b is opened to allow the second process gas to flow into the gas supply pipe 232b. The flow rate of the second process gas is controlled by the MFC 241b, supplied into the process chamber 201 via the nozzle 249b, and then exhausted through the exhaust port 233. In this case, the valve 243e is opened simultaneously to allow the inert gas to flow into the gas supply pipe 232b. In order to prevent the second process gas from entering the nozzles 249a and 249c, the valves 243f and 243g may be opened to allow the inert gas to flow into the gas supply pipes 232a and 232c.

In this case, the second process gas described above is supplied to the wafers 200.

### (Purge S24)

After a predetermined time has elapsed since the start of the supply of the second process gas, the valve 243b is closed to stop the supply of the second process gas into the process chamber 201. Then, residual gases remaining in the process chamber 201 are removed from the interior thereof by the same processing procedure as in the purge step S12 described above (Purge).

### (Performing Cycle Predetermined Number of Times)

By performing a cycle including S21 to S24 described above, i.e., performing S21 to S24 non-simultaneously a predetermined number of times (n times, where n is an integer of 1, 2, or greater), a film of predetermined composition and predetermined thickness can be formed on the wafer 200. Here, a polycrystalline film is formed as a film T1.

As the film T1 formed in this case, for example, a metal-containing film, which is a film containing a metal element, can be used. As the metal-containing film, for example, a transition metal-containing film, which is a film that contains a transition metal element selected from Group 3 to Group 11 elements, can be used. As the transition metal-containing film, for example, a Ti-, W-, Mo-, or Ta-containing film can be used. In addition, as the transition metal-containing film, for example, a transition metal nitride film can be used. As the transition metal nitride film, for example, a tantalum nitride (TaN) film, a tungsten nitride (WN) film, a molybdenum nitride (MoN) film, or a titanium nitride (TiN) film can be used. In addition, as the film T1, for example, a film composed of a single element such as Al, Si, Ga, or In, or a nitride film or the like can be used.

### (After-Purge and Restoration to Atmospheric Pressure)

After the film formation processing is completed, the inert gas as a purge gas is supplied from each of the nozzles 249a to 249c into the process chamber 201 and exhausted through the exhaust port 233. Thereby, the interior of the process chamber 201 is purged, and gases or reaction by-products remaining in the process chamber 201 are removed from the interior thereof (After-Purge). Thereafter, an internal atmosphere of the process chamber 201 is replaced with the inert gas (Replacement with Inert Gas), and pressure inside the process chamber 201 returns to atmospheric pressure (Restoration to Atmospheric Pressure).

### [Unloading of Wafer]

The seal cap 219 is lowered by the boat elevator 115, and the lower end of the manifold 209 is opened. Then, the processed wafers 200 are unloaded from the lower end of the manifold 209 to the outside of the reaction tube 203 while being supported on the boat 217 (Boat Unloading). After the boat is unloaded, the shutter 219s is moved and the lower end opening of the manifold 209 is sealed by the shutter 219s via the O-ring 220c (Shutter Close). The processed wafers 200 are unloaded to the outside of the reaction tube 203 and then discharged from the boat 217 (Wafer Discharging).

When the above-described film formation processing is performed, the film T1 is formed on the surfaces of members inside the process container, such as the inner wall of the reaction tube 203, the outer surfaces of the nozzles 249a to 249c, the inner surfaces of the nozzles 249a to 249c, the inner surface of the manifold 209, the surface of the boat 217, and the upper surface of the seal cap 219 and accumulates as a deposit. If the amount of the deposit, i.e., the accumulated film thickness of the film T1, becomes excessively thick, peeling of the deposited film occurs, which may lead to an increase in particle generation. For this reason, cleaning processing may be performed to remove all the deposited film deposited in the process container before peeling of the deposited film occurs, and a precoat film may be formed in the process container from which all the deposited film has been removed. In this case, productivity may decrease because it takes a long time to perform the cleaning processing and to form the precoat film.

In the embodiments of the present disclosure, first cleaning processing that cleans (or etches) the surface of the film T1 formed in the process container is performed every time the film formation process S20 is performed, i.e., every time substrate processing is performed. Then, second cleaning processing that removes a deposited film in the process container is performed when the accumulated film thickness in the process container becomes equal to or greater than a predetermined value. This makes it possible to shorten the time needed for cleaning and improve productivity. Here, the accumulated film thickness is the thickness of a film formed through the film formation process and is calculated by subtracting the amount etched through the first cleaning processing when the first cleaning processing has been performed. That is, the accumulated film thickness is calculated in such a manner that the accumulated film thickness formed in the process container is estimated by pre-storing the thickness of a film formed on the wafer 200 through, for example, one cycle of film formation processing and the amount etched through the first cleaning processing and counting the number of times of each processing whenever the film formation processing and the first cleaning processing are performed. Alternatively, the accumulated film thickness may be an actual measurement value. Alternatively, the accumulated film thickness may be calculated based on at least one selected from the group of a processing time, film formation processing, a flow rate of a gas used in the first cleaning processing, and pressure inside the process chamber 201.

### <Determination Process, Step S30>

Next, it is determined whether the accumulated film thickness is equal to or greater than a predetermined value. If the accumulated film thickness is less than the predetermined value, a first cleaning process S40, which will be described later, is performed. If the accumulated film thickness is equal to or greater than the predetermined value, a second cleaning process S50, which will be described later, is performed.

### <First Cleaning Process, Step S40>

In this process, the empty boat 217 is loaded into the process chamber 201, and first cleaning processing (also referred to as etching processing) in which at least a portion of the film T1 formed in the process container is capable of being removed (or etched) is performed. The first cleaning processing can also be referred to as simple cleaning or light cleaning that is performed in a short time for each film formation processing.

### [Loading of Empty Boat]

The shutter 219s is moved by the shutter opening/closing mechanism 115s, and the lower end opening of the manifold 209 is opened (Shutter Open). Thereafter, the empty boat 217, i.e., the boat 217 not charged with the wafers 200, is lifted by the boat elevator 115 and loaded into the process chamber 201. In this state, the seal cap 219 seals the lower end of the manifold 209 via the O-ring 220b. The first cleaning processing may be performed in a state in which the boat 217 is unloaded.

After the empty boat 217 is loaded into the process chamber 201, the process chamber 201 is vacuum-exhausted by the vacuum pump 246 so that the interior of the process chamber 201 reaches a desired pressure. The interior of the process chamber 201 is heated by the heater 207 so as to achieve a desired temperature. The rotator 267 starts to rotate the boat 217. The operation of the vacuum pump 246, the heating of the interior of the process chamber 201, and the rotation of the boat 217 are continuously performed at least until the completion of this process. The boat 217 may not need to be rotated. A processing temperature in this process is set to 400 to 500 degrees C, which is the same as a processing temperature in the above-described film formation process S20. A processing pressure in this process is set to be lower than a processing pressure in the film formation process S20.

The processing temperature used herein means the temperature of the wafer 200 or the temperature inside the process chamber 201, and the processing pressure means pressure inside the process chamber 201. The processing time means a time during which corresponding processing is continued. The same also applies to the following explanations. In this specification, the expression of a numerical range such as "400 to 500 degrees C" means that a lower limit and an upper limit are included in the range. Therefore, for example, "400 to 500 degrees C" means "400 degrees C or higher and 500 degrees C or lower." The same applies to other numerical ranges.

### [First Cleaning Processing]

First cleaning processing is performed by performing treatment S41, cleaning S42, and purge S43, which will be described later, a predetermined number of times (m times, where m is an integer of 1, 2, or greater).

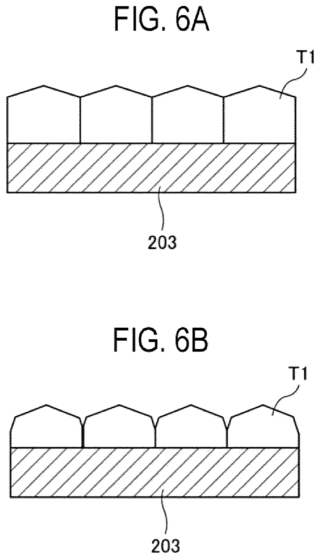

When the film formation process S20 is performed, the film T1 is deposited on the surfaces of the reaction tube 203 and the like as illustrated in FIG. 6A. The film T1 deposited in this case is a polycrystalline film and includes columnar crystals. Therefore, when cleaning processing is performed by supplying a cleaning gas to the film T1 in this state, the cleaning gas may enter crystal grain boundaries, as shown in FIG. 6B, and the film T1 may be scraped (etched) from the grain boundaries. For this reason, the surface of the film T1 to become uneven, resulting in increased surface roughness of the film T1. If the surface roughness of the film T1 is large, a surface area in the process container may become large, and the consumption amount of the process gas in the process container may differ. This may result in a difference in the amount of process gas supplied to the wafer 200, which may lead to non-uniform thickness of the film formed on the wafer 200. Furthermore, there are cases in which the film may partially peel off inside the process container, thereby generating particles.

In the present disclosure, treatment processing is performed before cleaning processing in the first cleaning processing. As a result, a film T2, which is a second film, is formed on a surface including the grain boundaries of the film T1, which is the polycrystalline film, formed in the process container. In other words, the surface including the grain boundaries of the film T1 is modified by a treatment gas to form the film T2 on the surface including the grain boundaries of the film T1. In this way, it is possible to prevent the grain boundaries of the film T1 from being exposed to the cleaning gas.

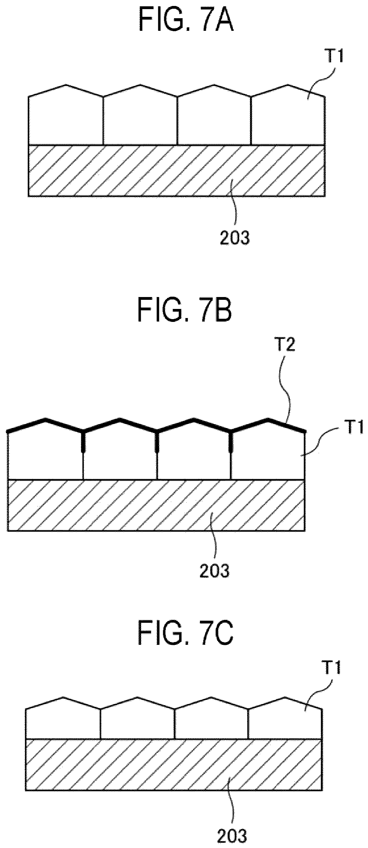

That is, by performing the treatment processing, the film T2 is formed, as illustrated in FIG. 7B, on the surface including the grain boundaries of the film T1 deposited on the surface of the reaction tube 203 as illustrated in FIG. 7A. That is, the film T2 is formed so as to fill the grain boundaries of the film T1. In this way, by allowing a component of the treatment gas to enter the grain boundaries of the film T1, it is possible to prevent the film T1 from being etched from the grain boundaries by the cleaning processing of the film T1. As a result, the film T1 is etched from above by the first cleaning processing described later, thereby improving the surface roughness of the film. Therefore, the amount of the process gas consumed by the wafer 200 can be made uniform for each wafer when processing the wafers 200. Here, "for each wafer" indicates any one or both of "for each wafer when a plurality of wafers is processed in a single process" and "for each wafer in each substrate processing (also referred to as "in each batch processing").

### (Treatment S41)

First, a third process gas is supplied into the process chamber 201. Specifically, the valve 243c is opened to allow the third process gas to flow into the gas supply pipe 232c. The flow rate of the third process gas is controlled by the MFC 241c, supplied into the process chamber 201 via the nozzle 249c, and then exhausted through the exhaust port 233. In this case, the valve 243g is opened simultaneously to allow an inert gas to flow into the gas supply pipe 232c. In order to prevent the third process gas from entering the nozzles 249a and 249b, the valves 243f and 243e may be opened to allow the inert gas to flow into the gas supply pipes 232a and 232b.

Here, for example, the third treatment gas as the treatment gas is supplied into the process container. The treatment gas in this step may be supplied continuously or in divided portions. As the treatment gas, it is possible to use a gas that alone can form a film or a gas capable of changing the surface condition of a target film. For example, a Si-containing gas can be used as the treatment gas. For example, a silane-based gas such as SiH₄ gas, Si₂H₆ gas, or Si₃H₈ gas can be used as the Si-containing gas. In addition to the above-described Si-containing gas, for example, an oxidizing gas or a metal-containing gas can be used. As the oxidizing gas, for example, oxygen (O₂) gas, ozone (O₃) gas, water vapor (H₂O) gas, hydrogen peroxide (H₂O₂) gas, a mixed gas of hydrogen (H₂) and O₂, nitrous oxide (N₂O) gas, nitrogen nitric oxide (NO) gas, nitrogen dioxide (NO₂) gas, or the like may be used. At least one selected from the group of these gases can be used as the oxidizing gas. As the metal-containing gas, for example, hafnium chloride (HfCl₄) gas, zirconium chloride (ZrCl₄) gas, tungsten hexafluoride (WF₆) gas, tungsten hexachloride (WCl₆) gas, molybdenum pentachloride (MoCl₅) gas, molybdenum dichloride dioxide (MoO₂Cl₂) gas, molybdenum tetrachloride oxide (MoOCl₄) gas, molybdenum hexafluoride (MoF₆) gas, molybdenum difluoride dioxide (MoO₂F₂) gas, molybdenum tetrafluoride oxide (MoOF₄) gas, or the like can be used. As the treatment gas, one or more of these gases can be used. As the treatment gas, a gas that can fill the grain boundaries of a film to be cleaned is desirable. In other words, a gas that can form a film on the grain boundaries is desirable. The gas capable of forming the film on the grain boundaries in this way includes the Si-containing gas or the metal-containing gas of the present disclosure. Although it is difficult to form a film with the oxidizing gas alone, an etching rate of an oxidized part may be reduced by oxidizing the surface of the film to be cleaned (particularly the grain boundaries). In this case, etching proceeds from other parts of the grain boundaries, so surface roughness may be improved. More desirably, a gas that seals a halogen element in a film in the process container is desirable, and a gas that does not contain the halogen element is used. In the example of the present disclosure, for example, a silane-based gas or an oxidizing gas is used.

In addition, the treatment gas is supplied to the film T1 in a state in which the treatment gas is decomposed. This allows the surface of the film T1 to be modified to form the film T2. Here, the state in which the treatment gas is decomposed includes, for example, supplying the treatment gas at a temperature equal to or higher than a decomposition temperature of the treatment gas. In addition, the state in which the treatment gas is decomposed is, for example, a state in which the film T1 is composed of a catalyst for the treatment gas. That is, the film T1 is desirably a film that serves as the catalyst for the treatment gas. By performing processing in the state in which the treatment gas is decomposed, an element contained in the treatment gas can be precipitated at the grain boundaries of the film T1. Further, by supplying the treatment gas to the film as the catalyst, a temperature adjustment time can be shortened during the substrate processing, cleaning processing, etching processing, and treatment processing (also referred to as the modification processing). Thereby, throughput can be improved in a semiconductor device manufacturing process.

The film T2 formed in this case is a film with lower crystallinity than the film T1 and is, for example, an amorphous film. This allows the grain boundaries of the film T1, which is the polycrystalline film, to be filled with the film T2. An etching rate (a second etching rate) of the film T2 when the cleaning gas is supplied is equal to or less than an etching rate (a first etching rate) of the film T1 when the cleaning gas is supplied. Desirably, the etching rate of the film T2 when the cleaning gas is supplied is set to be smaller than the etching rate of the film T1 when the cleaning gas is supplied. The thickness of the film T2 formed in this case is set to be thinner than the thickness of the film T1. As a result, the film T1 is etched from above by the first cleaning processing described later, thereby improving the surface roughness of the film.

Furthermore, as the film T2, for example, a film containing an element selected from Group 13 elements, Group 14 elements, Group 15 elements, or Group 16 elements is formed. As the film containing the element selected from Group 13 elements, Group 14 elements, Group 15 elements, or Group 16 elements, for example, a film containing Si, boron (B), oxygen (O), or phosphorus (P) can be used. As the film containing Si, B, O, or P, for example, a silicon nitride (SiN) film, a silicon oxide (SiO) film, a TiSiN film, a B film, a boron nitride (BN) film, a P film, or a TiPN film can be used.

Specifically, when, for example, SiH₄ gas is used as the treatment gas, a decomposition temperature of the SiH₄ gas is, for example, 350 to 400 degrees C. Further, when a TiN film is used as the film T1, for example, the SiH₄ gas is easily decomposed on the TiN film, and the TiN film is a film that serves as a catalyst for SiH₄.

### (Cleaning S42)

Next, a cleaning gas is supplied into the process chamber 201. Specifically, the valve 243d is opened to allow the cleaning gas to flow into the gas supply pipe 232a. A flow rate of the cleaning gas is controlled by the MFC 241d, supplied into the process chamber 201 via the nozzle 249a, and then exhausted through the exhaust pipe 231. In this case, the valve 243f is opened simultaneously to allow the inert gas to flow into the gas supply pipe 232a. In order to prevent the cleaning gas from entering the nozzles 249b and 249c, the valves 243e and 243g may be opened to allow the inert gas to flow into the gas supply pipes 232b and 232c.

For example, a halogen-based gas can be used as the cleaning gas. For example, nitrogen trifluoride (NF₃) gas, fluorine (F₂) gas, chlorine (Cl₂) gas, hydrogen fluoride (HF) gas, chlorine trifluoride (ClF₃) gas, hydrogen chloride (HCl) gas, boron trichloride (BCl₃) gas, bromine (Br₂) gas, or the like can be used as the cleaning gas. As the cleaning gas, one or more of these gases can be used.

As a result, the cleaning gas is supplied to the film T1, on the surface of which, including the grain boundaries, the film T2 formed, and at least a portion of the film T1 is removed.

After a predetermined time has passed and the first cleaning processing in the process chamber 201 has been completed, the valve 243d is closed to stop the supply of the cleaning gas into the process chamber 201.

### (Purge S43)

After a predetermined time has elapsed since the start of the supply of the third process gas, the valve 243c is closed to stop the supply of the third process gas into the process chamber 201. Then, residual gases remaining in the process chamber 201 are removed from the interior thereof by the same processing procedure as in the purge step S12 described above (Purge).

### (Performing Cycle Predetermined Number of Times)

The film T1 in the process container is etched so as to be a predetermined thickness by performing a cycle including S41 to S43 described above, i.e., performing the cycle including non-simultaneously a predetermined number of times (m times, where m is an integer of 1, 2, or greater).

Processing conditions for the first cleaning (etching) processing are as follows:
Supply flow rate of cleaning gas: 0.1 to 10 slm
Supply flow rate of inert gas (each gas supply pipe): 0 to 10 slm
Supply time of each gas: 5 to 300 seconds, desirably 100 to 200 seconds
Processing temperature: 200 degrees C or higher and lower than 900 degrees C, preferably 300 to 800 degrees C, more desirably 350 to 600 degrees C
Processing pressure: 150 to 400 Pa, desirably 200 to 300 Pa. When the supply flow rate includes 0 slm, 0 slm means that a corresponding gas is not supplied. This applies to other explanations of this disclosure.

The first cleaning processing is completed by the above series of operations.

When performing, for example, a TiN film in the film formation process S20, abnormally grown nuclei grow along with the crystal growth of TiN. In this process, the abnormally grown nuclei formed on the surface of the TiN film inside the process container are removed (etched). As a result, the surface of the TiN film formed in the process container is etched and planarized.

### [Unloading of Empty Boat]

After the first cleaning processing is completed, the seal cap 219 is lowered by the boat elevator 115, and the lower end of the manifold 209 is opened. Then, the empty boat 217 is unloaded from the lower end of the manifold 209 to the outside of the reaction tube 203 (Boat Unloading). After the boat is unloaded, the shutter 219s is moved and the lower end opening of the manifold 209 is sealed by the shutter 219s via the O-ring 220c (Shutter Close). Subsequently, a next plurality of wafers 200 is charged onto the boat 217 to perform the above-described film formation process S20.

### <Second Cleaning Process, Step S50>

In this process, the empty boat 217 is loaded into the process chamber 201, and second cleaning processing in which the deposition film deposited on the inner wall of the process container and the like and the precoat film are removed for a longer time than first cleaning processing described above is performed. That is, when the cycle of steps S41 to S43 described above is performed a predetermined number of times (m times, where m is an integer of 1, 2, or greater) and when the accumulated film thickness inside the process container is equal to or greater than a predetermined value, the second cleaning process is performed. As a result, the film deposited inside the process container is removed.

### [Loading of Empty Boat]

The shutter 219s is moved by the shutter opening/closing mechanism 115s, and the lower end opening of the manifold 209 is opened (Shutter Open). Thereafter, the empty boat 217, i.e., the boat 217 not charged with the wafers 200, is lifted by the boat elevator 115 and loaded into the process chamber 201. In this state, the seal cap 219 seals the lower end of the manifold 209 via the O-ring 220b. Alternatively, the second cleaning processing may be performed in a state in which the boat 217 is unloaded.

After the empty boat 217 is loaded into the process chamber 201, the process chamber 201 is evacuated by the vacuum pump 246 so that the interior of the process chamber 201 reaches a desired pressure. The interior of the process chamber 201 is heated by the heater 207 so as to achieve a desired temperature. The rotator 267 starts to rotate the boat 217. The operation of the vacuum pump 246, the heating of the interior of the process chamber 201, and the rotation of the boat 217 are continuously performed at least until the completion of this process. Alternatively, the boat 217 may not need to be rotated.

### [Second Cleaning Processing]

In this process, the above-described cleaning gas is supplied into the process chamber 201. Specifically, the valve 243d is opened to allow the cleaning gas to flow into the gas supply pipe 232a. The flow rate of the cleaning gas is controlled by the MFC 241d, supplied into the process chamber 201 via the nozzle 249a, and then exhausted through the exhaust pipe 231. In this case, the valve 243f may be opened simultaneously to allow the inert gas to flow into the gas supply pipe 232a. In order to prevent the cleaning gas from entering the nozzles 249b and 249c, the valves 243e and 243g may be opened to allow the inert gas to flow into the gas supply pipes 232b and 232c.

After a predetermined time has elapsed and the second cleaning processing in the process chamber 201 has been completed, the valve 243d is closed to stop the supply of cleaning gas into the process chamber 201. That is, the cleaning gas is supplied into the process container in which a film to be cleaned is formed for a time longer than the supply time of the cleaning gas during the first cleaning processing. Then, the interior of the process chamber 201 is purged by the same processing procedure as in purge S12 described above (Purge). Thereafter, the internal atmosphere of the process chamber 201 is replaced with the inert gas (Replacement with Inert Gas).

The second cleaning processing is completed by the above series of operations.

### [Unloading of Empty Boat]

After the second cleaning processing is completed, the seal cap 219 is lowered by the boat elevator 115, and the lower end of the manifold 209 is opened. Then, the empty boat 217 is unloaded from the lower end of the manifold 209 to the outside of the reaction tube 203 (Boat Unloading). After the boat is unloaded, the shutter 219s is moved and the lower end opening of the manifold 209 is sealed by the shutter 219s via the O-ring 220c (Shutter Close).

After the second cleaning process S50 is performed, the precoating process S10 is performed to form a precoat film in the process container. That is, the interior of the process container is precoated.

In this process, when the thickness of the deposition film deposited in the process container becomes equal to or greater than the predetermined value, the second cleaning processing is performed. In the second cleaning processing, the deposition film deposited in the process container and the precoat film are etched. That is, by performing the second cleaning processing, even the precoat film formed in the process container is etched.

That is, when the accumulated film thickness in the process container after the substrate processing is less than the predetermined value, the first cleaning processing is performed in a short time, and when the accumulated film thickness in the process container after the substrate processing becomes equal to or greater than the predetermined value, the second cleaning processing is performed. This makes it possible to perform cleaning efficiently in a short time compared to the case in which the above-described first cleaning processing is not performed.

### (3) Other Embodiments

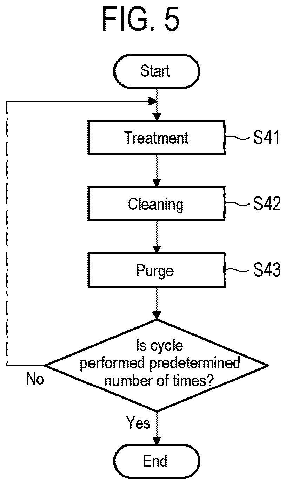

The embodiments of the present disclosure have been specifically described hereinabove. However, the present disclosure is not limited to the above-described embodiments, and various changes may be made without departing from the gist thereof. In other embodiments described below, the substrate processing apparatus is used in the same manner as shown in FIG. 1, and components that are substantially the same as those described in FIG. 1 and processes that are substantially the same as those shown in FIGS. 4 and 5 are denoted by the same reference numerals and descriptions thereof will be omitted.

### (Second Embodiments)

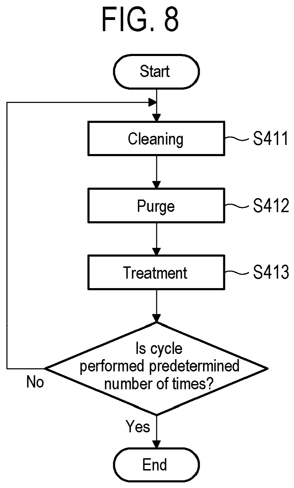

Next, other embodiments of the above-described first cleaning processing will be described with reference to FIG. 8. In these embodiments, first cleaning processing is performed by performing cleaning S411, purge S412, and treatment S413 a predetermined number of times (m times, where m is an integer of 1, 2, or greater). That is, the procedure of each processing is different from that of the first cleaning processing described earlier. In addition, cleaning S411, purge S412, and treatment S413 are performed in the same manner as cleaning S42, purge S43, and treatment S41 described earlier.

In these embodiments, the same effects as those of the above-described embodiments are obtained. In these embodiments, since cleaning is performed after treatment from the second cycle onward, the deterioration of the surface roughness of the film T1 can be improved in the same manner as in the above-described embodiments. In these embodiments, treatment S413 is performed at the end of the first cleaning processing, so that components contained in the cleaning gas can be suppressed from remaining in the reaction tube 203. That is, in the next film formation process S20, the components contained in the cleaning gas can be suppressed from being adsorbed onto the wafer 200.

### (Third Embodiments)

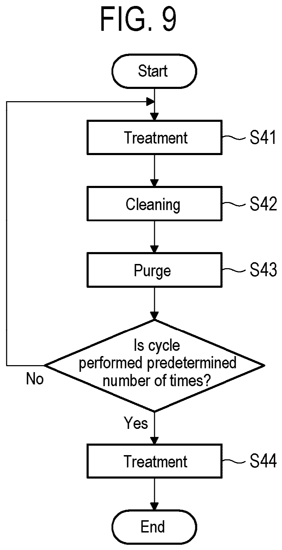

Next, other embodiments of the second cleaning processing will be described with reference to FIG. 9. In these embodiments, after treatment S41, cleaning S42, and purge S43 in the above-described embodiments are performed a predetermined number of times (m times, where m is an integer of 1, 2, or greater), treatment S44 is performed. That is, treatment S44 is performed after the processing shown in FIG. 5 is performed. Treatment S44 is performed in the same manner as treatment S41 described above. That is, treatment is performed before and after cleaning.

Even in these embodiments, deterioration of the surface roughness of the film T1 can be improved as in the above-described embodiments. Further, in these embodiments, components contained in the cleaning gas can be suppressed from remaining in the reaction tube 203. That is, the components contained in the cleaning gas can be suppressed from being adsorbed onto the wafer 200 in the next film formation process S20.

In the above-described embodiments, the case in which the film T1 formed in the process container is cleaned (etched) has been exemplarily described. However, the present disclosure is not limited thereto and can be suitably applied to the case in which the film T1 formed on the wafer 200 is etched. That is, the present disclosure is suitably applicable to the case in which the film T2 is formed on the surface including the grain boundaries of the film T1 formed on the wafer 200, and the film T1 formed on the wafer 200 is etched. In these embodiments, the surface roughness of the film formed on the surface of the wafer 200 can be reduced. This can improve the uniformity of a film formed on the surface of the wafer 200 and improve the characteristics of a semiconductor device. In addition, as a substrate to which the present embodiments are applied, any one or both of a product substrate and a dummy substrate can be used. The product substrate is a substrate used as the semiconductor device. By applying these embodiments to a film formed on the product substrate, the surface roughness of a film that forms one structure of the semiconductor device can be improved. In addition, the dummy substrate is a substrate used when processing the product substrate. The dummy substrate is, for example, a monitor substrate used for inspection or the like or a fill dummy substrate used to make gas consumption uniform. By applying these embodiments to a film formed on the dummy substrate, the amount of gas consumed by the dummy substrate can be made uniform for each substrate processing. As a result, the amount of consumption of a process gas supplied to each product substrate can be uniformized.

A recipe used for each processing is desirably prepared individually according to processing content and stored in the memory 121c via an electric communication line or the external memory 123. When starting each processing, the CPU 121a desirably selects an appropriate recipe according to processing content from a plurality of recipes recorded and stored in the memory 121c. This makes it possible to reproducibly form films of various film types, composition ratios, film qualities, and film thicknesses in a single substrate processing apparatus. It is also possible to reduce the burden on an operator and to quickly initiate each processing while avoiding operational errors.

The above-described recipe is not limited to a newly prepared recipe and may be prepared by, for example, changing an existing recipe that has already been installed in the substrate processing apparatus. In the case of changing the recipe, a recipe after the change may be installed in the substrate processing apparatus via an electric communication line or a recording medium in which the recipe is recorded. Further, the input/output device 122 provided in an existing substrate processing apparatus may be operated to directly change the existing recipe that has already been installed in the substrate processing apparatus

In the above-described embodiments, an example in which a film is formed using a batch type substrate processing apparatus that processes a plurality of substrates at a time has been described. The present disclosure is not limited to the above-described embodiments and may be suitably applied to, for example, the case in which a film is formed using a single-wafer type substrate processing apparatus that processes one or several substrates at a time. In the above-described embodiments, an example in which a film is formed using a substrate processing apparatus including a hot-wall type process furnace has been described. The present disclosure is not limited to the above-described embodiments and may also be suitably applied to, for example, the case in which a film is formed using a substrate processing apparatus including a cold-wall type process furnace.

Even when these substrate processing apparatuses are used, each processing may be performed by the same processing procedures and processing conditions as those of the above-described embodiments or other embodiments, and the same effects as those of the above-described embodiments or other embodiments are obtained.

The above-described embodiments or other embodiments may be used in combination as appropriate. The processing procedures and processing conditions in this case can be, for example, the same as those of the above-described embodiments or other embodiments.

### EXPLANATION OF REFERENCE NUMERALS

200: wafer (substrate). 203: reaction tube

## Claims

1. A processing method, comprising:
(a) forming a second film, whose etching rate is a second etching rate that is equal to or lower than a first etching rate of a first film when a first gas capable of removing at least a portion of the first film is supplied, on the first film; and
(b) supplying the first gas to the first film.

2. The processing method of Claim 1, wherein the second etching rate is lower than the first etching rate.

3. The processing method of Claim 1, wherein (a) is performed before (b) or after (b).

4. The processing method of Claim 1, wherein (a) and (b) are performed a predetermined number of times.

5. The processing method of Claim 1, further comprising removing the first film by supplying the first gas after performing (a) and (b) a predetermined number of times.

6. The processing method of Claim 1, wherein the first film is a film containing a metal element.

7. The processing method of Claim 6, wherein the metal element is a transition metal element.

8. The processing method of Claim 1, wherein the second film contains an element selected from Group 13 elements, Group 14 elements, Group 15 elements, or Group 16 elements.

9. The processing method of Claim 1, wherein the first film and the second film are formed in a process container.

10. The processing method of Claim 1, wherein the first film and the second film are formed on a substrate.

11. The processing method of Claim 1, wherein the first film is a polycrystalline film, and the second film is a film whose crystallinity is lower than the first film.

12. The processing method of Claim 1, wherein the first film is a polycrystalline film, and the second film is an amorphous film.

13. The processing method of Claim 1, wherein a thickness of the second film is thinner than a thickness of the first film.

14. The processing method of Claim 1, wherein, in (a), the second film is formed by supplying a second gas to the first film in a state in which the second gas is decomposed.

15. The processing method of Claim 14, wherein the state in which the second gas is decomposed includes a temperature equal to or higher than a decomposition temperature of the second gas.

16. The processing method of Claim 14, wherein the state in which the second gas is decomposed is a state in which the first film is composed of a catalyst for the second gas.

17. A processing apparatus, comprising:
a first gas supply system configured to supply a first gas capable of removing at least a portion of a first film; and
a controller configured to be capable of controlling the first gas supply system so as to perform a process comprising:
(a) forming a second film, whose etching rate is a second etching rate that is equal to or lower than a first etching rate of the first film when the first gas is supplied, on the first film; and
(b) supplying the first gas to the first film.

18. A method of manufacturing a semiconductor device, comprising:
(a) forming a second film, whose etching rate is a second etching rate that is equal to or lower than a first etching rate of a first film when a first gas capable of removing at least a portion of the first film is supplied, on the first film; and
(b) supplying the first gas to the first film.

19. A program that causes, by a computer, a processing apparatus to perform a process comprising:
(a) forming a second film, whose etching rate is a second etching rate that is equal to or lower than a first etching rate of a first film when a first gas capable of removing at least a portion of the first film is supplied, on the first film; and
(b) supplying the first gas to the first film.
